# EUROPEAN PATENT APPLICATION

(11) **EP 1 298 717 A1**
(43) Date of publication of application: **02.04.2003**
(21) Application number: 01122648.7
(22) Date of filing: 27.09.2001
(51) Int. Cl.: H01L 21/322, H01L 21/324, H01L 21/26, H01L 21/329

(54) **Method for manufacturing a semiconductor device having a pn junction area**

(71) Applicant: S.H.I. Examination & Inspection, Ltd., Toyo-shi, Ehime (JP); Jo, Jungyol, Suwon 442-749 (KR)
(72) Inventor: Nishihara, Yoshiaki, 1501, Imazaike, Toyo-shi, Ehime (JP); Jo, Jungyol, Paldal-Gu, Suwon 442-749 (KR)
(74) Representative: Geyer, Ulrich F., Dr. Dipl.-Phys.

(57) **Abstract**

The present invention provides a method for manufacturing a semiconductor device having a junction area formed by doping with a first conductive and a second conductive dopant. According to the method of the present invention, a surface of the semiconductor device is irradiated by electron beams or charged particles having energy of 100 to 500 keV. After the irradiation by electron beams or charged particles, annealing in a hydrogen atmosphere is performed for the irradiated semiconductor device.

## Description

### BACKGROUND OF THE INVENTION

The present invention relates to a method for manufacturing a semiconductor device and, more particularly, to a method for manufacturing a semiconductor device having a p-n junction.

Power semiconductor devices, such as a diode, an insulated gate bipolar transistor (IGBT) or a thyristor, have p-n junction structures. In silicon semiconductor devices having the p-n junctions mentioned above, the resistance of the silicon is decreased by injection of minority carriers using a forward current so that the voltage drop is decreased as small as possible in a turn-on state.

A method for adjusting the resistance of a semiconductor device by using minority carriers is called "conductivity modulation" and, in particular, is effectively used when the lifetime of minority carriers is long. Since silicon has the indirect bandgap, the lifetime of the minority carriers is relatively long. Accordingly, various adjusting methods have been used in practice in order to achieve the object described above.

However, according to the adjusting methods described above, excess minority carriers already injected cannot be quickly removed when a semiconductor device is turned off, and as a result, a problem may arise in that operation speed of the semiconductor device is decreased.

When the lifetime of minority carriers is short, since the minority carriers quickly combine with majority carriers therearound and disappear, the problem described above does not occur. However, in the case of silicon, since the lifetime of the minority carriers is long, only some of the excess minority carriers disappear by recombination with majority carriers, and hence, the remaining excess minority carriers, which do not recombine, generate a reverse current.

Accordingly, when the lifetime of the minority carriers is long, the recombination does not sufficiently occur, and hence, the number of the minority carriers that generate a reverse current is increased. As a result, the turn-off time is not only increased, but the consumption of electrical power represented by the product of a current and a voltage is also increased.

In recent years, since most of the power semiconductor devices repeat an on-off operation at a frequency in kHz, the electrical power consumed at each turn-off considerably decreases the energy efficiency of the semiconductors.

As a method for solving the problem described above, a method has been currently used which decreases the lifetime of the minority carriers by intentionally forming defects in a silicon substrate.

As a method for forming the defects, a method was used which diffused gold, platinum, or the like in a silicon semiconductor substrate. However, in recent years, a method has been widely used which forms defects by irradiating a silicon substrate with charged particles, such as high-energy electrons having energy of approximately 2 MeV or protons having even higher speed.

However, in the case of the irradiation with electrons, the apparatus thereof is large since high energy is required, and hence, a problem may arise in that the cost is increased. That is, in a treatment using an electron beam apparatus for irradiating with high-energy electrons having energy of approximately 2 MeV, it is believed that the cost of radiating electrons is five to six times that of an electron beam source which irradiates with electrons having energy of 500 keV or less.

### SUMMARY OF THE INVENTION

Accordingly, it is an object of the present invention to provide a method for manufacturing a semiconductor device that can be done with low energy electrons and has an improved switching speed.

The present invention relates to a method for manufacturing a semiconductor device having a junction area formed by doping with a first conductive dopant and a second conductive dopant. According to the method of the present invention, a surface of the semiconductor device is irradiated by electron beams or charged particles having energy in the range of from 100 to 500 keV. During or after the irradiation by electron beams or charged particles, annealing is performed for the irradiated semiconductor device in a hydrogen atmosphere.

The hydrogen atmosphere preferably includes hydrogen plasma atmosphere.

The annealing may be performed by irradiation of the electron beams in the hydrogen atmosphere.

The irradiation by the electron beams or charged particles forms unstable defects in the semiconductor device, and the annealing changes the unstable defects into stable defects.

In the case described above, the stable defects are formed by a reaction between the unstable defects and hydrogen.

In the case described above, the stable defects are formed by high dose irradiation (preferably 1 E17/cm² or more in the case of electron irradiation) even without annealing with hydrogen.

In addition, the junction area contains minority carriers, and the stable defects serve to decrease the lifetime of the minority carriers.

The annealing is preferably performed at a temperature in the range of from 100°C to 350°C for 30 to 60 minutes.

The charged particles may be electrons or ionized particles.

### BRIEF DESCRIPTION OF THE DRAWINGS

Fig. 1 is a cross-sectional view of a diode which is irradiated by electrons according to a manufacturing method of the present invention;
Fig. 2 is a graph showing the on-voltage of the diode shown in Fig. 1 when the diode is irradiated by electrons having energy of 270 keV followed by annealing in a hydrogen atmosphere;
Fig. 3 is a graph showing the measurement results of a current flowing through the diode shown in Fig. 1 when a voltage applied thereto in the forward direction is changed to that in the reverse direction; and
Fig. 4 is a graph showing the integral value of the reverse current with respect to the change in the forward current when the diode shown in Fig. 1 is irradiated by electrons having energy of 270 keV followed by annealing in a hydrogen atmosphere.

If the device is electron-irradiated up to 1 E17/cm² of dose range or more, similar results of electron beam /H⁺, H₂" can be achieved

### DESCRIPTION OF THE PREFERRED EMBODIMENTS

In a method for manufacturing a semiconductor device according to the present invention, a surface of the semiconductor device having a junction area formed by doping with a first conductive dopant and a second conductive dopant is irradiated by particles, such as electrons having energy of 100 to 500 keV or charged particles having energy of several MeV. In addition, the method described above includes an annealing step that is performed in a hydrogen atmosphere during or after the irradiation by charged particles. This annealing step is preferably performed at a temperature of approximately 100°C to 350°C for 30 to 60 minutes.

The method of the present invention decreases electron energy required for irradiation, stabilizes generated defects by a hydrogen step or high dose irradiation, that is, by the annealing step in a hydrogen or hydrogen plasma atmosphere or by the excessive bombardment of particles, and effectively decreases the lifetime of minority carriers. The annealing may be performed by irradiation of the electron beams in the hydrogen atmosphere.

In general, it has been known that electron energy of 500 keV or less is too low for irradiation by electrons, and that defects formed inside silicon are unstable.

In order to solve the problem described above, by performing the hydrogen step described above, the method of the present invention effectively decreases the lifetime of minority carriers even by radiating electrons having energy of approximately 100 to 500 keV.

Silicon atoms are bombarded with electrons and are then knocked out from the equilibrium positions in the crystal lattice, thereby forming defects. Accordingly, a new energy level is generated in the bandgap of the silicon. In this embodiment, spaces formed by the bombardment of the silicon atoms by the electrons are called vacancies, and an interstitial atom denotes the atom existing at a position different from the original position thereof in the crystal structure due to the bombardment. Accordingly, when the interstitial atom recombines with a vacancy, the original state can be recovered.

In the hydrogen step or with high dose irradiation, hydrogen atoms injected in the silicon interfere with the recombination described above. Since electrons having high energy of approximately 2 MeV, which are generally used for this purpose, can place a silicon atom at a position far away from the original position, it is considerably difficult for the silicon atom to return to the original position. However, since electrons having energy of 500 keV or less cannot place a silicon atom at a position relatively far away from the original position, it is relatively easy for the silicon atom to return to the original position, and hence, defects already formed are likely to disappear with time or with an increase in temperature of the semiconductor device.

The present invention was made in view of the facts described above and in consideration of the phenomenon described below. That is, defects formed by electrons having energy of approximately 100 to 500 keV can be changed into stable defects by a reaction with hydrogen during an annealing step performed in a hydrogen or a hydrogen plasma atmosphere.

In other words, the manufacturing method of the present invention uses the phenomenon in that when hydrogen ions are located in the vicinity of the defects formed by electron beams having low energy, it is difficult for the interstitial atoms to recombine with vacancies. Accordingly, when the vacancies are filled with hydrogen atoms, the effect of decreasing the lifetime by irradiation by electron beams can be further increased. The same results can be achieved by high dose irradiation, because excessive bombardment of particles stabilizes the defects.

As described above, according to the method for manufacturing the semiconductor device of the present invention, by irradiating the semiconductor device with electrons or ionized particles having energy of 100 to 500 keV, defects can be formed in the semiconductor device, and as a result, an effective decrease in lifetime of the minority carriers can be achieved in addition to the reduction in facility and production cost.

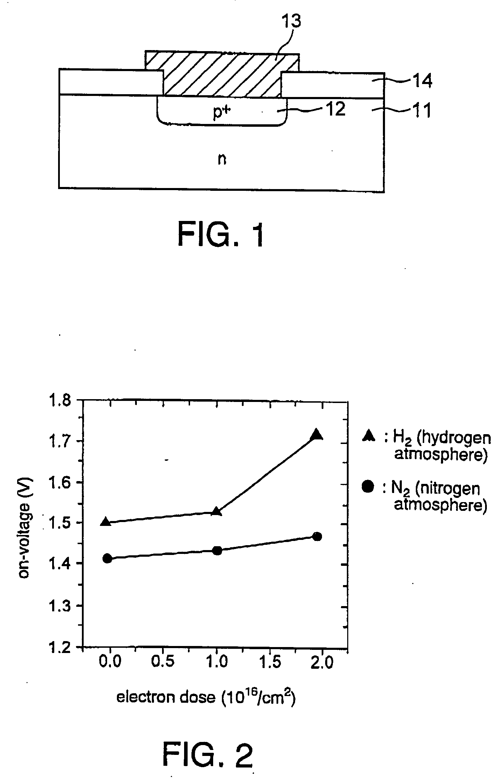

Referring to Fig. 1, a preferable embodiment of the present invention will be described in detail. As shown in Fig. 1, an oxide film 14 is formed on a surface of an n-type silicon substrate 11. A part of the oxide film 14 thus formed is removed. A p⁺ doped region 12 is formed by ion implantation of a p-type dopant in the n-type silicon substrate 11 at a position corresponding to that at which the oxide film 14 was removed. Accordingly, a p⁺ n-diode is formed. A metal electrode 13 is formed on the P⁺ doped region 12 of the n-type substrate 11 and on an oxide film 14 in the vicinity of the P⁺ doped region 12. Aluminum, molybdenum, gold, silver, or tungsten is used for forming the metal electrode 13.

According to this embodiment, the p⁺ n-diode described above is irradiated by charged particles such as electrons or ionized particles having low energy.

Electron beam energy used in this embodiment is approximately 100 to 500 keV. This energy level means that a low-energy electron beam apparatus which is generally used for irradiating electrons can be used in the present invention.

When a low-energy electron beam apparatus irradiates silicon lattices by charged particles, unstable defects are formed in the silicon; however, according to the data described below, the above-mentioned defects can be changed into stable defects by a reaction with hydrogen. Hydrogen ions have significantly high reactivity with the defects described above, and hence, hydrogen ions can satisfactory combine with the defects which exist at positions of a few tens of micrometers from the surface of the semiconductor device.

Accordingly, when hydrogen atoms exist in the vicinity of the defects (that is, vacancies) formed by low-energy electrons, it is difficult to cause the interstitial atoms that were knocked out from their original positions to return to the vacancies, and hence, the defects can exist in a stable state.

As described above, since the number of the defects in a stable state is increased, the lifetime of the minority carriers in the semiconductor device can be effectively decreased.

Fig. 2 is a graph showing the on-voltage of the p⁺ n-diode shown in Fig. 1 when the diode is irradiated by electron beams having low energy followed by annealing in a hydrogen or a nitrogen atmosphere.

The on-voltage in the present invention is defined as the forward voltage drop of a diode when a forward current of 5 mA flows by turning on the diode.

The diameter of the diode used for the experiment was 100 µm, and the resistivity and an annealing temperature were 20 ohm-cm and 300°C, respectively. The energy of irradiated electrons was 270 keV.

As shown in Fig. 2, the diode annealed in a nitrogen atmosphere has an on-voltage of 1.41 to 1.47 V in the range of the electron dose shown in Fig. 2. In the case described above, it is understood that the change in on-voltage substantially does not occur with an increase in electron dose of this range.

However, when annealing is performed in a hydrogen atmosphere, the on-voltage is 1.50 to 1.73 V in the same range of electron dose as that in the nitrogen atmosphere. In the case described above, it is understood that the on-voltage is significantly increased with an increase in electron dose.

Accordingly, since the forward voltage drop of the diode is increased by hydrogen, the hydrogen serves to stabilize the defects, and as a result, it can be confirmed that the lifetime of the minority carriers is decreased.

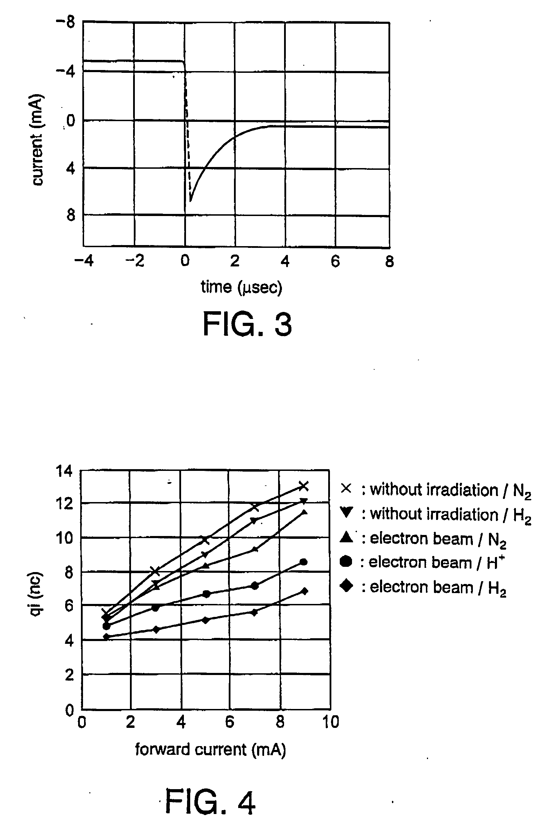

Fig. 3 is a graph showing a current flowing through the diode shown in Fig. 1 when the voltage applied thereto in the forward direction is changed to that in the reverse direction in order to verify the turn-off property of the diode. In the case described above, the forward current was set to 5 mA.

As can be seen from the graph shown in Fig. 3, it is understood that the reverse current is increased to approximately 7 mA at a switching time and is then exponentially decreased.

The reverse current measured at the switching time primarily includes a current generated by excess minority carriers that are not consumed by recombination.

When the total amount of charge of the excess minority carriers, the amount of charge obtained by integrating the reverse current with time, and the amount of charge which is consumed by recombination are represented by Qᵣᵣ, Qᵢ, and Q_{rec,} respectively, since Qᵣᵣ disappears by the counteraction between the reverse current and the current generated by the recombination, the equation, Qᵣᵣ = Qᵢ + Q_{rec}, holds.

In this equation, Qᵣᵣ is defined as the integral value of the forward current in the range of the lifetime of the minority carriers. Accordingly, when the forward current is increased, Qᵣᵣ, Qᵢ, and Q_{rec} described above are increased in proportion to the increase in forward current.

Fig. 4 is a graph showing the integral value of the reverse current with respect to the forward current in order to show that the lifetime of the minority carriers is decreased when the diode shown in Fig. 1 is irradiated by electron beams. The diode shown in Fig. 1 has a current property like that shown in Fig. 3, and the irradiation was performed by electron beams having energy of 270 keV at a dose of 2 × 10¹⁶ electrons/cm² followed by annealing in a hydrogen plasma atmosphere. In the case described above, the annealing was performed at 300°C for 30 minutes.

As can be seen in Fig.4, it is understood that Qᵢ, which is the integral value of the reverse current of the p⁺ n-diode with time, is increased with the increase in forward current. In the relationship between Qᵢ and the forward current, the smaller the slope in the graph, the shorter the lifetime. The reason for this is that since the total amount of charge of the excess minority carriers, i.e, Qᵣᵣ, is defined as the sum of Qᵢ and the amount of charge that disappears by recombination, i.e, Q_{rec}, and Qᵣᵣ is proportional to Qᵢ, as shown in Fig. 3, when the rate of the increase in Qᵢ with the increase in forward current, that is, the slope shown in the figure, is relatively small, it means that the rate of the increase in Qᵣᵣ is small.

Annealing in a nitrogen atmosphere was performed at 300°C for 30 minutes as in the case of that in a hydrogen atmosphere. As can be seen in Fig. 4, the smallest slope of Qᵢ is obtained by annealing in a hydrogen atmosphere after the irradiation by electron beams. This result means that the lifetime of the minority carriers is most decreased by the irradiation with electron beams and the annealing in a hydrogen or a hydrogen plasma atmosphere. When annealing in a nitrogen atmosphere is performed after the irradiation by electron beams, the slope is approximately equivalent to that obtained when the irradiation by electron beams is not performed, and hence, it is understood that the decrease in lifetime of the minority carriers is not significant.

Heretofore, the preferable embodiments of the present invention have been described; however the present invention is not limited thereto. For example, the present invention may be naturally applied to an n⁺ n-diode in addition to a p⁺ n-diode, and more particularly, may also be applied to all semiconductor devices having a p-n junction, such as a bipolar transistor (BIT), a metal oxide field effect transistor (MOS), an insulated gate bipolar transistor (IGBT), and a thyristor.

In addition, the case in which the semiconductor substrate is irradiated by electrons is described in the preferable embodiments of the present invention; however, when the substrate is irradiated by charged particles such as protons (electropositive particle), ionized particles or the like, the same advantage as that obtained by the irradiation with electrons can be obtained.

According to the present invention, by irradiating a semiconductor substrate with electrons or charged particles having energy of 100 to 500 keV and by subsequently performing annealing in a hydrogen or a hydrogen plasma atmosphere or by high dose irradiation so as to form stable defects in the semiconductor device, the lifetime of the minority carriers can be effectively decreased in addition to the reduction in facility and production cost.

## Claims

1. A method for manufacturing a semiconductor device having a junction area formed by doping with a first conductive dopant and a second conductive dopant, the method comprising:
irradiating a surface of the semiconductor device by electron beams or charged particles having energy in the range of from 100 to 500 keV; and
annealing the irradiated semiconductor device in a hydrogen atmosphere after the irradiation by electron beams or charged particles.

2. A method for manufacturing a semiconductor device according to claim 1, wherein the hydrogen atmosphere includes a hydrogen plasma atmosphere.

3. A method for manufacturing a semiconductor device according to claim 1, wherein the annealing is performed by irradiation of the electron beams in the hydrogen atmosphere.

4. A method for manufacturing a semiconductor device according to claim 1, wherein the annealing is performed by high dose irradiation.

5. A method for manufacturing a semiconductor device according to claim 1, wherein the irradiation by electron beams or charged particles forms unstable defects in the semiconductor device, and the annealing step changes the unstable defects into stable defects.

6. A method for manufacturing a semiconductor device according to claim 5, wherein the stable defects are formed by a reaction between the unstable defects and hydrogen.

7. A method for manufacturing a semiconductor device according to claim 5, wherein the junction area contains minority carriers, and the stable defects serve to decrease the lifetime of the minority carriers.

8. A method for manufacturing a semiconductor device according to claim 1, wherein the annealing step is performed at a temperature in the range of from 100°C to 350°C for 30 to 60 minutes.

9. A method for manufacturing a semiconductor device according to claim 1, wherein the charged particles are electrons.

10. A method for manufacturing a semiconductor device according to claim 1, wherein the charged particles are ionized particles.
